# FASCICULE DE BREVET EUROPEEN

(11) **EP 0 952 426 B1**
(45) Date de publication et mention de la délivrance du brevet: **03.09.2003**
(21) Numéro de dépôt: 98110729.5
(22) Date de dépôt: 11.06.1998
(51) Int. Cl.: G01B 7/30, H03K 17/97, H03K 17/975, G04C 3/14, G01D 5/20

(54) **Pièce d'horlogerie comprenant un dispositif de détection inductif ou capacitif d'au moins une position angulaire de référence d'une roue de cette pièce d'horlogerie**
Uhrwerk mit einem induktiven oder kapazitiven Sensor zur Detektion von mindestens einem Drehwinkel eines Zahnrades innerhalb des Uhrwerkes
Timepiece having an inductive or capacitive sensor for detecting at least one angular position of gear-wheel within the timepiece

(30) Priorité: 24.04.1998 CH 93798
(43) Date de publication de la demande: 27.10.1999
(73) Titulaire: ASULAB S.A., CH-2501 Bienne (CH)
(72) Inventeur: Born, Jean-Jacques, 1110 Morges (DE); Farine, Pierre-André, 2003 Neuchâtel (DE); Passeraub, Philippe, 1022 Chavannes (DE)
(74) Mandataire: Balsters, Robert

(56) Documents cités:
- WO-A-97/45705
- DE-A- 3 828 810
- FR-A- 1 512 207

## Description

La présente invention concerne une pièce d'horlogerie comprenant un mouvement horloger, pourvu d'un affichage analogique et d'au moins un mobile solidaire en rotation d'un indicateur ou moyen d'affichage rotatif de cet affichage analogique, et un dispositif de détection d'au moins une position angulaire de référence dudit mobile, ce dispositif de détection comprenant un capteur inductif ou capacitif.

Plus particulièrement, l'invention concerne un dispositif de détection d'au moins une position angulaire de référence d'une roue dentée du rouage d'un mouvement horloger.

L'homme du métier connaît les dispositifs optiques de détection d'au moins une position angulaire de référence de roue appartenant au rouage d'un mouvement horloger. Tous ces dispositifs optiques de détection sont relativement complexes. Ils nécessitent une source lumineuse et un récepteur de lumière distant de cette source. Le montage d'un dispositif de détection optique est souvent délicat étant donné l'ajustement précis nécessaire entre la source lumineuse, le récepteur et la ou les roue(s) associée(s) à ce dispositif. Dans le cadre de la présente invention, il est donc prévu de s'affranchir de tout système optique de détection de la position d'une roue dans un mouvement horloger.

Il est connu de l'abrégé anglais de la demande internationale WO 97/45705 un système de détection de la position de roues coaxiales respectivement associées à des aiguilles coaxiales d'un mouvement horloger. Sur chaque roue dentée pleine sont agencées plusieurs parties discrètes d'un film dur magnétique qui définissent un motif d'identification pour un capteur magnétique sans contact. Chacune des roues dont il est prévu de pouvoir détecter la position angulaire est associée à un propre capteur magnétique. L'amplitude du signal détecté par ces capteurs magnétiques varie selon qu'ils sont situés devant un segment de matériau magnétique ou non, comme cela ressort des figures 3 et 4 de cette demande de brevet internationale. Le système de détection proposé dans ce document est désavantageux par le fait que chaque roue associée à un capteur magnétique doit être munie de segments ou parties distinctes d'un film solide en matériau magnétique agencés sur une face de la roue dentée. Le coût de fabrication des roues est donc augmenté et l'agencement du motif d'identification est prévu sur un plateau plein de la roue dentée, ce qui peut être un inconvénient pour la marche du mouvement horloger. Les plateaux des roues sont donc formés d'au moins deux matériaux différents, à savoir le matériau formant la base du plateau de la roue et le matériau magnétique agencé à la surface de cette base.

Un but de la présente invention est de pallier les inconvénients susmentionnés en fournissant une pièce d'horlogerie comprenant un dispositif de détection sans contact de la position angulaire d'au moins un demi-axe de référence d'une roue qui soit de construction simple et qui engendre une moindre complication du mouvement horloger.

A cet effet, la présente invention concerne une pièce d'horlogerie comprenant :
- un mouvement horloger pourvu d'un affichage analogique et comportant au moins une roue solidaire en rotation d'un moyen d'affichage rotatif dudit affichage analogique, cette roue comprenant un plateau avec une denture définie par son bord externe et un arbre perpendiculaire à ce plateau;
- un dispositif de détection de la position angulaire d'au moins un demi-axe géométrique de référence de ladite roue, ce dispositif comprenant un capteur inductif ou capacitif pourvu d'un organe de détection;
ledit plateau de la roue étant constitué par un matériau dont une variation de présence au-dessus ou au-dessous de l'organe de détection du capteur engendre une variation d'au moins un paramètre ou une variable de ce capteur dont dépend un signal de mesure fourni par celui-ci. Ledit plateau présente au moins une ouverture située dans sa région intermédiaire entre un trou central, prévu pour le passage dudit arbre, et ladite denture. Cette ouverture sert à définir ledit au moins un demi-axe géométrique de référence. Le capteur est agencé relativement à la roue de manière que son organe de détection soit au moins partiellement au-dessous ou au-dessus de ladite ouverture dans au moins une position angulaire donnée de ladite roue.

Grâce aux caractéristiques de l'invention susmentionnées, la roue associée au capteur sans contact peut avoir un plateau constitué d'un seul matériau conventionnel pour les roues d'un mouvement horloger, notamment un métal électriquement conducteur comme le laiton.

Le plateau de la roue associée au dispositif de détection n'a pas à être formé d'un matériau aimanté de manière permanente, ni à supporter des éléments aimantés avec le type de capteur sans contact sélectionné.

Comme on le comprendra encore mieux à l'aide de la description ci-après, l'invention permet de détecter au moins un demi-axe géométrique de référence d'une roue formée de manière conventionnelle avec un usinage approprié du plateau de cette roue, en particulier de ladite au moins une ouverture.

A titre d'exemple pour le circuit électronique du capteur inductif ou capacitif prévu dans le cadre de la présente invention, on se référera au document EP 0746100 qui décrit un capteur de proximité inductif ou capacitif, lequel est intégré par référence à la présente description.

Selon un mode de réalisation particulier de l'invention, le demi-axe géométrique de référence de la roue part perpendiculairement de l'axe géométrique de rotation de cette roue et passe par le centre géométrique de ladite ouverture.

Ainsi, une seule ouverture prévue dans le plateau de la roue permet au dispositif de détection selon l'invention de déterminer la position angulaire de la roue. L'usinage d'une ouverture dans un plateau de roue est une opération très bon marché, laquelle est d'ailleurs déjà prévue dans certains types de roues pour limiter le poids de la roue et également le coût en matériau. Ainsi, la présente invention n'engendre aucune complication du mouvement horloger conventionnel pour permettre la détection de la position angulaire d'une roue.

Selon un autre mode de réalisation particulier, le plateau de ladite roue associée au dispositif de détection présente dans sa région intermédiaire au moins une ouverture et un bras radial, la direction médiane de ce bras définissant un demi-axe géométrique de référence de cette roue dont la position angulaire peut être détectée par le dispositif de détection selon l'invention.

Ainsi, dans le cadre de la présente invention, la position angulaire d'une roue peut être déterminée par une direction radiale et médiane d'une ouverture ou d'un bras, notamment en forme de secteur annulaire. De plus, comme cela sera décrit ci-après, il est également possible dans le cas de la présente invention de définir un demi-axe géométrique de référence d'une roue par une transition entre une ouverture et une partie matérielle du plateau de cette roue, le type de capteur prévu dans un mode préféré de la présente invention permettant une détection d'une telle transition lorsque cette transition permet de définir une direction radiale particulière de la roue.

La présente invention sera décrite de manière plus détaillée à l'aide de la description suivante, faite en référence aux dessins annexés, donnés à titre d'exemples nullement limitatifs et dans lesquels :
- la figure 1 représente une roue dentée d'un mouvement horloger associée à un capteur inductif de détection d'un demi-axe géométrique de référence de cette roue;
- la figure 2 est une vue schématique en coupe représentant partiellement un mouvement horloger comportant la roue dentée et le capteur inductif représentés à la figure 1;
- la figure 3 montre schématiquement une courbe formée à l'aide de mesures effectuées par le capteur inductif représenté aux figures 1 et 2, cette courbe permettant de déterminer le demi-axe de référence de la roue représentée sur ces figures 1 et 2;
- la figure 4 représente schématiquement une variante de la roue de la figure 1;
- la figure 5 représente schématiquement un mode de réalisation particulier d'une roue dentée associée à un capteur inductif selon l'invention;
- la figure 6 montre un graphe obtenu par des mesures effectuées par le capteur inductif de la figure 5 dont l'analyse permet la détermination d'au moins un demi-axe de référence de la roue représentée sur cette figure;
- la figure 7 montre un graphe obtenu à l'aide de mesures effectuées par le capteur inductif de la figure 5 lors du passage d'une ouverture à une partie pleine au-dessus de l'organe inductif formé par une bobine plane en spirale;
- la figure 8 montre schématiquement un mode de réalisation particulier de l'invention;
- les figures 9 et 10 représentent schématiquement deux variantes de la roue représentée à la figure 5 dont l'agencement permet la détection de plusieurs demi-axes de référence de la roue.

Les modes de réalisation décrits ci-après comprennent tous un capteur inductif étant donné que les développements et prototypes réalisés dans le cadre de la présente invention ont été effectués avec un capteur inductif intégré nouvellement développé. Les résultats obtenus avec ce capteur inductif intégré comportant une seule bobine plane en spirale de petites dimensions donnent de très bon résultats. Cependant, un capteur intégré du type capacitif peut également être prévu à la place d'un capteur inductif. On notera toutefois que le capteur inductif est moins sensible à l'environnement et aux perturbations engendrées par les tolérances de fabrication et de montage qu'un capteur capacitif.

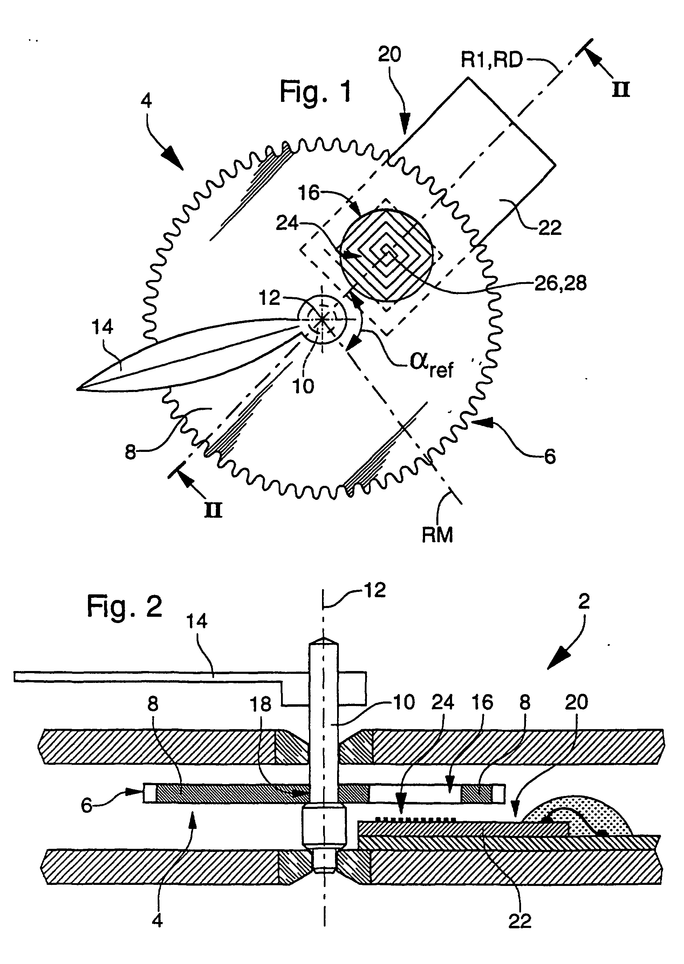

A l'aide des figures 1 à 3, on décrira ci-après un premier mode de réalisation de l'invention. Le mouvement horloger 2 comporte une roue dentée 4 avec une denture 6 définie par le bord externe du plateau 8. La roue 4 comprend en outre un arbre 10 définissant un axe géométrique de rotation 12. Le mouvement horloger 2 est associé à un affichage analogique comprenant un indicateur rotatif 14 monté fixement sur l'arbre 10. L'indicateur 14 peut servir à indiquer l'heure, la minute, la seconde ou de toute autre information utile prévue pour un affichage analogique. Le plateau 8 est monté fixement sur l'arbre 10 de sorte que l'indicateur 14 est solidaire de ce plateau 8.

Le plateau 8 présente une ouverture circulaire 16 dans sa région intermédiaire, c'est-à-dire entre le trou central 18 prévu pour le passage de l'arbre 10 et la denture 6. Un capteur inductif 20, formé d'un circuit intégré 22 et d'une bobine plane en spirale 24 agencée sur une face du circuit intégré, est agencé relativement au plateau 8 de la roue 4 de manière que la bobine plane 24 soit au moins partiellement au-dessous de l'ouverture 16 dans au moins une position angulaire donnée de la roue 4, comme représenté à la figure 1.

On notera que le capteur 20 peut, de manière équivalente, être agencé au-dessus du plateau 8 de manière que la bobine plane 24 soit au moins partiellement située en regard de l'ouverture 16 dans au moins une position angulaire donnée de la roue 4. De préférence, il est prévu que l'axe magnétique central 26 de la spirale formant la bobine plane 24 passe sensiblement par le centre 28 de l'ouverture 16 dans une position angulaire donnée prise par la roue 4, comme représenté à la figure 1. L'angle de référence α_{ref} est défini entre une direction de référence RM du mouvement horloger et le demi-axe géométrique de référence RD du capteur 20, parallèle au plateau 8, qui part de l'axe géométrique 12 et croise l'axe magnétique central 26 de la bobine 24. Le demi-axe géométrique de référence R1 de la roue 4 part de l'axe géométrique 12 et passe par le centre 28 de l'ouverture circulaire 16. A la figure 1, les demi-axes R1 et RD sont confondus.

On remarquera que l'indicateur 14 peut présenter un décalage angulaire quelconque relativement à la direction du demi-axe R1.

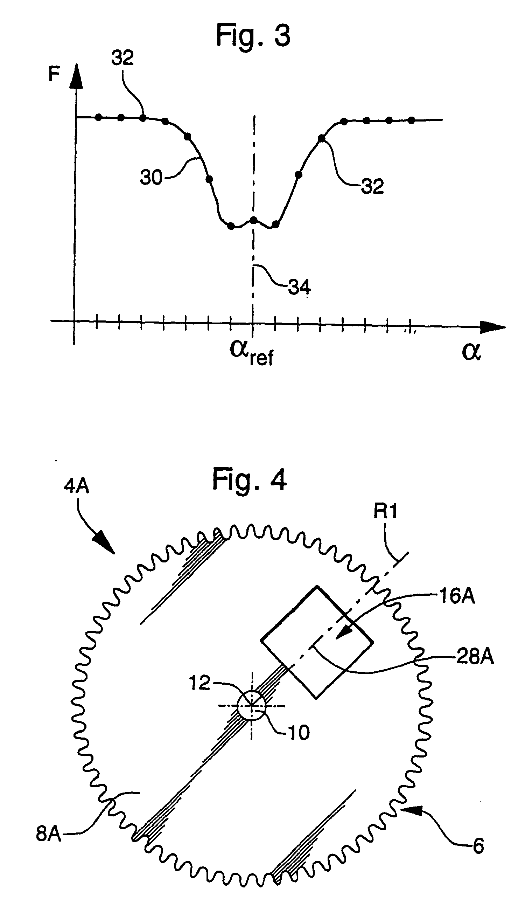

La figure 3 montre schématiquement un graphe 30 défini par des points de mesure 32 obtenus par le capteur 20. Selon l'invention, le plateau 8 est constitué par un matériau non aimanté, c'est-à-dire n'est pas constitué par un aimant permanent, mais par un matériau dont une variation de proximité relativement à la bobine plane 24 engendre une variation d'au moins un paramètre ou une variable du capteur 20 dont dépend un signal de mesure fourni par ce capteur. Le capteur inductif prévu dans ce mode de réalisation comprend un circuit électronique similaire à celui décrit dans le document EP 0746100, ce capteur définissant un oscillateur à relaxation différentiel. Ce signal de mesure fourni par le capteur 20 est représentatif d'une fréquence déterminée par le circuit électronique de ce capteur, cette fréquence variant en fonction de la variation de présence du matériau constituant le plateau 8 au-dessus ou au-dessous de l'organe de détection défini par la bobine 24. La variation de ladite fréquence résulte de la variation de la valeur de l'inductance de la bobine 24 au sein du circuit électronique du capteur 20. Lorsque cette bobine 24 est en regard du matériau non aimanté constituant le plateau 8, la fréquence a une valeur haute. Par contre, lorsque la bobine 24 est située sensiblement en regard de l'ouverture 16 usinée dans le plateau 8, la fréquence est basse. La courbe 30 définit schématiquement l'évolution de la valeur de la fréquence engendrée par le capteur en fonction de la position angulaire du demi-axe de référence R1 de la roue 4 qui, comme dit précédemment, part de l'axe géométrique 12 et passe par le centre 28 de l'ouverture circulaire 16.

On remarquera que la courbe 30 est sensiblement symétrique relativement à l'axe 34 correspondant à la valeur α = α_{ref}. Ainsi, à l'aide d'une analyse appropriée de l'évolution des points de mesure 32 en fonction de la position angulaire α du demi-axe R1 de la roue 4, il est possible de déterminer quelle mesure correspond à la position angulaire α = α_{ref} du demi-axe R1, c'est-à-dire lorsque ce dernier est sensiblement parallèle au demi-axe de référence RD du capteur 20 qui est fixe relativement au mouvement horloger.

On remarquera que le graphe 30 peut présenter un pic au lieu d'un creux suivant la réalisation du circuit électronique prévu ou du matériau constituant le plateau 8. Avec le capteur inductif proposé ici à titre d'exemple non limitatif, le matériau du plateau 8 est soit un métal électriquement conducteur, soit un matériau de haute perméabilité magnétique. De préférence, le matériau sélectionné est un métal conducteur ayant une perméabilité magnétique égale à 1 ou proche de 1, c'est-à-dire un métal non ferromagnétique comme de l'aluminium ou du laiton largement utilisé pour la fabrication de roues et autres parties de mouvements horlogers.

On notera que la largeur du pic ou du creux dans le graphe 30 est fonction de la dimension angulaire de l'ouverture de référence ou, comme cela sera décrit ci-après, du bras radial de référence. Il est possible de prévoir une petite dimension angulaire de cette ouverture (une fente) ou de ce bras radial et/ou une fréquence de mesure faible et/ou un entraînement pas à pas définissant des sauts angulaires suffisamment importants pour qu'un seul point de mesure définisse essentiellement le pic ou le creux. Dans un tel cas, il suffit de détecter lorsqu'une mesure donne une valeur de fréquence inférieure, respectivement supérieure à une valeur de seuil pour détecter le passage de la fente, respectivement du pic (ou inversement suivant le capteur 20 prévu). Une telle mesure correspond ainsi à une position angulaire α du demi-axe R1 égale à α_{ref}. Par conséquent la position angulaire de la roue est déterminée directement lorsque les demi-axes de référence RD et R1 sont confondus sans nécessiter une détermination ultérieure de la mesure du capteur qui correspond à cette situation. On remarquera qu'un tel cas particulier simplifie le traitement des résultats de mesure, mais diminue généralement la sensibilité du dispositif de détection selon l'invention.

Dans le cas représenté à la figure 3, la mesure correspondant à α = α_{ref} peut être déterminée par des moyens électroniques connus de l'homme du métier. On citera par exemple le calcul du point milieu de la largeur à une hauteur caractéristique du creux de la courbe 30, la détermination de la valeur supérieure entre deux valeurs minimales lorsqu'il y a une oscillation sur la courbe 30 comme représentée à la figure 3, ou encore la détermination du second passage par zéro de la dérivée de la courbe 30 à l'aide d'un dérivateur électronique (également dans le cas où une oscillation intervient). Dans le cas où l'on est en présence d'un pic, des analyses équivalentes sont également applicables.

Il ressort de ce qui vient d'être exposé que le dispositif de détection est agencé pour permettre d'effectuer plusieurs mesures successives, en particulier à une fréquence de consigne donnée. Ensuite, il comprend une mémoire pour enregistrer une ou des succession(s) de résultats de mesures dans un mode de réalisation où la courbe de mesure pour la détection du demi-axe R1 est similaire à la courbe 30. De plus, dans ce cas, l'évolution temporelle de la rotation résultant de la commande des moyens d'entraînement de la roue 4 doit être mémorisée sous une forme appropriée pour permettre de déterminer le décalage angulaire instantané du demi-axe R1 relativement à α_{ref} une fois que le résultat de mesure correspondant à la position angulaire α du demi-axe R1 égale à α_{ref} a été identifiée. Finalement, si l'on veut conserver la connaissance de la position angulaire α sur une certaine période temporelle, il est nécessaire de continuer à suivre ladite évolution temporelle durant cette période.

Dans le cas conventionnel où les moyens d'entraînement de la roue 4 sont formés par un moteur pas à pas, un comptage des pas peut se faire aisément et chaque mesure peut être enregistrée avec un adressage dépendant du "numéro" du pas, notamment lorsqu'une mesure par pas est effectuée.

Dans le cas d'un entraînement continu, une référence temporelle est nécessaire et l'évolution temporelle de l'angle α du demi-axe R1 peut se déduire aussi de la commande du moteur synchrone entraînant en rotation (directement ou indirectement par l'intermédiaire d'un train d'engrenages) la roue 4. L'homme du métier peut réaliser des circuits électroniques accomplissant cette fonction de suivi de la rotation de la roue 4 et de détermination de la position angulaire instantanée du demi-axe de référence R1. On comprend aisément que le cas particulier d'une détection directe de α = α_{ref} simplifie les moyens électroniques de traitement nécessaires.

Pour détecter le demi-axe de référence R1 lorsque la position angulaire de la roue 4 est perdue ou pas connue, il est prévu une commande d'initialisation où le moteur entraînant cette roue 4 est commandé dans un mode rapide et le dispositif de détection est activé de manière à déterminer la position angulaire du demi-axe R1 lors de son passage au-dessus ou au-dessous de la bobine 24 du capteur 20.

Pour vérifier si la position du demi-axe R1 est correcte (lors de la marche du mouvement horloger), il est prévu d'activer le dispositif de détection lors du passage attendu de ce demi-axe R1 dans la région du capteur 20. En cas de position incorrecte, les moyens de commande du moteur corrigent la position angulaire de ce demi-axe R1. Si il n'est pas détecté, le mode d'initialisation susmentionné est activé.

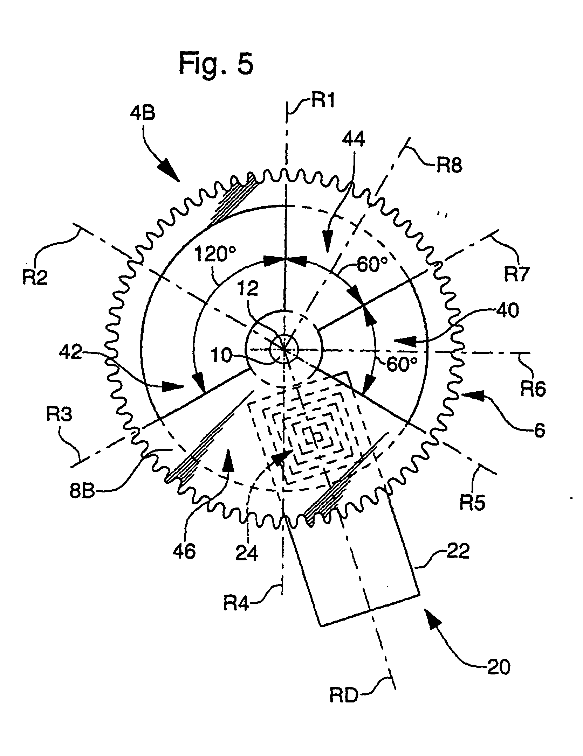

Sur la figure 4 est représentée une roue 4A ayant un plateau 8A qui présente une ouverture carrée 16A. Le demi-axe de référence R1 passe par le centre géométrique 28A de l'ouverture 16A. Cette roue 4A forme une variante de réalisation de la roue 4 de la figure 1.

La figure 5 représente schématiquement un deuxième mode de réalisation d'une pièce d'horlogerie selon l'invention dans laquelle le capteur 20 est identique à celui décrit aux figures 1 et 2. La roue 4B associée au capteur 20 présente deux ouvertures 40 et 42 en forme de secteur annulaire. L'ouverture 40 définit un angle au centre de 60° alors que l'ouverture 42 définit un angle au centre de 120°. Ces deux ouvertures sont situées dans la région intermédiaire du plateau 8B située entre le trou central prévu pour le passage de l'arbre 10 et la denture 6. Les deux ouvertures 40 et 42 sont séparées l'une de l'autre par deux parties matérielles 44 et 46 définissant respectivement des angles au centre de 60° et 120°.

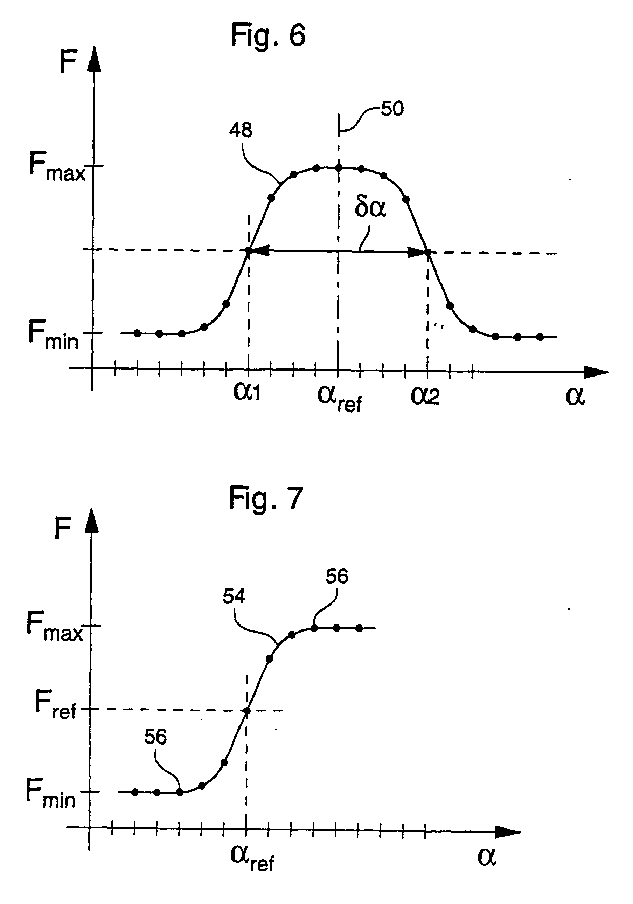

Comme cela a été mentionné précédemment, les mesures effectuées de manière répétitive lors de la rotation de la roue 4B par le capteur 20 permet de déterminer les positions angulaires des demi-axes de référence R2 et R6 de cette roue. La détection par le capteur 20 des positions angulaires des demi-axes de référence R4 et R8, respectivement confondus avec les directions médianes des parties annulaires 46 et 44, est effectuée de manière équivalente à la détection des positions angulaires des demi-axes R2 et R6. En effet, le passage au-dessus de la bobine 24 de la section annulaire 44 ou 46 engendre une augmentation de la fréquence mesurée par le capteur, comme cela est représenté à la figure 6. Lorsque le demi-axe de référence R2 ou R6 est sensiblement confondu au demi-axe RD défini par le capteur 20, la fréquence mesurée par le capteur correspond sensiblement à F_{min,}, alors que la fréquence mesurée a sensiblement la valeur Fₘₐₓ lorsque la bobine 24 est entièrement recouverte par l'une des sections annulaires 44 ou 46. Etant donné que la courbe résultant des mesures effectuées par le capteur 20 lors du passage d'une section annulaire pleine définit une courbe 48 sensiblement symétrique, les moyens électroniques associés au capteur permettent de déterminer la position milieu donnée par la droite verticale 50, correspondant à la position angulaire α_{ref}, de la manière décrite ci-avant en référence aux figures 1 à 3.

La configuration du plateau 8B de la roue 4B représentée à la figure 5 permet de définir encore quatre autres demi-axes de référence R1, R3, R5 et R7 de la roue 4B. Comme cela a déjà été mentionné précédemment, le capteur 20 est sensible à une variation de présence du matériau formant le plateau 8B au-dessus ou au-dessous de la bobine 24. Lors de la transition d'une partie pleine, à savoir d'un des secteurs annulaires 44 et 46, à une ouverture 40 ou 42, la fréquence du signal de mesure du capteur 20 passe d'une valeur Fₘₐₓ à une valeur Fₘᵢₙ.

A la figure 7 est représentée la courbe définie par les différents points de mesures obtenus lors d'une transition d'une ouverture 40 ou 42 à un bras ou partie annulaire 44 ou 46. La courbe 54, définie par les points de mesure 56 passe progressivement de la valeur de fréquence Fₘᵢₙ à la valeur de fréquence Fₘₐₓ lors d'une augmentation de l'angle α du demi-axe R3 ou R7 dans le cas où la roue 4B tourne dans le sens horaire, respectivement du demi-axe R1 ou R5 si la roue 4B tourne dans le sens anti-horaire. Il est possible de déterminer sensiblement la position α = α_{ref} en déterminant l'angle pour lequel la courbe 54 correspond à la fréquence F_{ref} dont la valeur est une valeur milieu entre Fₘᵢₙ et Fₘₐₓ. Ainsi, avec le dispositif de détection prévu dans le présent mode de réalisation, il est possible de détecter le bord d'une ouverture lorsque ce bord définit une direction radiale du plateau, comme c'est le cas à la figure 5.

Un secteur annulaire défini par une ouverture ou par une partie matérielle dans la région intermédiaire du plateau permet de définir trois demi-axes de références de la roue comportant ce plateau. Cela ressort en particulier du graphe 48 représenté à la figure 6 qui correspond sensiblement au passage du secteur annulaire 44 au-dessus de la bobine 24 du capteur 20. L'analyse du graphe 48 permet de déterminer quel point de mesure correspond à l'alignement du demi-axe R8 sur le demi-axe de référence RD du capteur et les points de mesures correspondant à l'alignement du demi-axe R7, respectivement R1 sur le demi-axe RD. Ces derniers points de mesures correspondent respectivement aux angles α1 et α2 de la figure 6 lorsque la roue 4B tourne dans le sens horaire. La différence angulaire δα = α2-α1 est déterminée par la dimension angulaire du secteur annulaire 44 ou 46 et, dans la situation inverse, de la dimension angulaire de l'ouverture 40 ou 42.

Ainsi, une mesure de δα permet de déterminer si c'est la partie annulaire 44 ou 46 qui a passé au-dessus de la bobine 24. De même, en mesurant la largeur à mi-hauteur d'un creux dans un graphe équivalent pour les points de mesures résultant du passage d'une ouverture 40 ou 42 en regard de la bobine 24, il est possible de déterminer laquelle de ces ouvertures a passé au-dessus de la bobine 24. Il résulte de ces considérations que l'analyse des mesures successives par le capteur 20 lors de la rotation de la roue 4B permet de déterminer de manière univoque les positions angulaires de chacun des demi-axes de référence R1 à R8. Le plateau 8B définit ainsi six demi-axes de référence détectable par le capteur 20 qui sont décalés l'un relativement à l'autre d'un angle de 60°. De plus, deux demi-axes de référence R6 et R8 sont également détectables. Une fois la position angulaire d'un demi-axe déterminée, les positions angulaires des autres demi-axes sont également déterminées. En règle générale, un seul demi-axe de référence est suffisant pour déterminer la position angulaire d'une roue dans un mode d'initialisation et pour vérifier au cours du temps une avance correcte de la roue relativement à une avance de consigne déterminée par des moyens de référence.

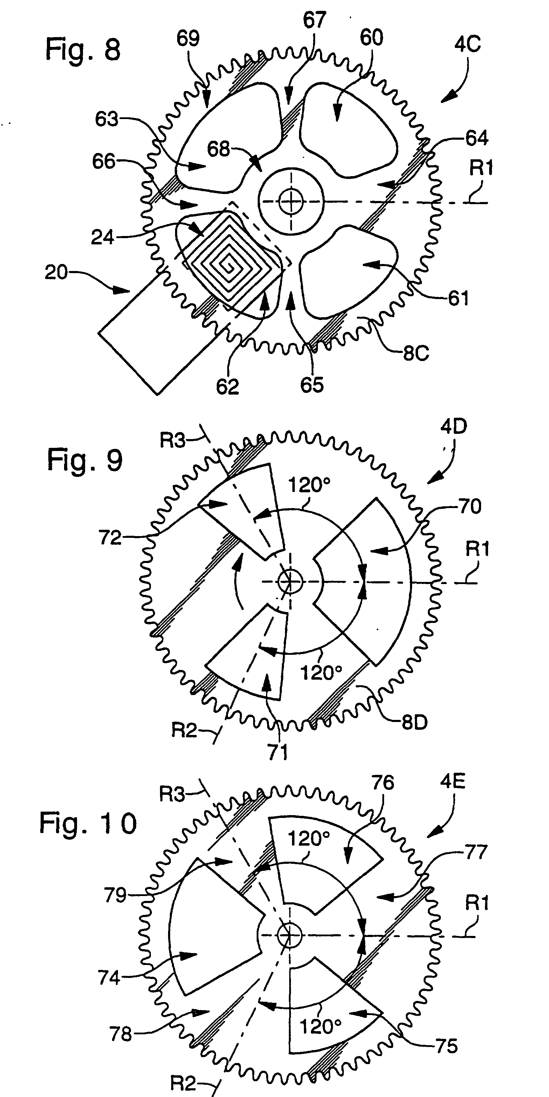

A la figure 8, est représenté un autre mode de réalisation d'une roue 4C associée à un dispositif de détection selon l'invention. Ce dispositif de détection comprend à nouveau un capteur 20 pourvu d'une bobine plane en spiral 24. Le plateau 8C présente quatre ouvertures 60 à 63 définissant quatre bras radiaux 64 à 67 reliant le moyeu 68 à la jante 69 de la roue 4C. Le bras radial 64 a une dimension angulaire supérieure aux trois autres bras. La ligne médiane de ce bras 64 définit le demi-axe géométrique de référence R1 de la roue 4C qui est confondu avec cette ligne médiane.

Etant donné la différence de dimension angulaire entre le bras 64 et les autres bras, il est possible de déterminer le passage de ce bras au-dessus de la bobine 24, comme cela a été expliqué précédemment à l'aide de la figure 6. La détection de la position angulaire du demi-axe R1 est identique à la détermination des demi-axes R4 et R8 décrite à l'aide des figures 5 et 6.

Ce mode de réalisation est avantageux par le fait que le plateau 8C présente des ouvertures réparties sensiblement uniformément de telle manière que ce plateau est sensiblement équilibré. Pour équilibrer au mieux le plateau 8C, il est possible d'augmenter l'épaisseur de matière du bras 66 ou, de manière équivalente, de diminuer la quantité de matière du côté du bras 64. Il est également possible de diminuer quelque peu les ouvertures 63 et 64 pour obtenir un équilibrage optimum du plateau 8C. Tout autre moyen connu de l'homme du métier est envisageable. En particulier, il est encore possible de prévoir un arrangement différent des bras 65, 66 et 67. Il est également possible de prévoir un bras en moins ou en plus pour obtenir un équilibrage satisfaisant du plateau 8C.

Sur les figures 9 et 10 sont représentées deux variantes d'un autre mode de réalisation. Le plateau 8D de la roue 4D représenté à la figure 9 définit notamment trois demi-axes de référence R1, R2 et R3 qui sont décalés angulairement de 120° et sont définis respectivement par les droites médianes des ouvertures 70, 71 et 72. On remarquera que la dimension angulaire de l'ouverture 70 est supérieure aux dimensions angulaires respectives des ouvertures 71 et 72 qui sont identiques. Bien que les ouvertures 71 et 72 soient identiques, elles définissent toutefois les demi-axes de référence R2 et R3 de manière univoque étant donné que la roue 4D tourne dans un sens déterminé, par exemple dans le sens horaire.

La variante représentée à la figure 10 représente une roue 4E dont le plateau 8E présente également trois parties annulaires séparées par trois ouvertures 74, 75 et 76. Les trois parties annulaires ou bras radiaux 77, 78 et 79 ont chacun une dimension radiale spécifique différente, à savoir 80°, 60° et 40°. Les demi-axes R1, R2 et R3 sont détectés de manière univoque quelque soit le sens de rotation de la roue.

## Revendications

1. Pièce d'horlogerie comprenant :
- un mouvement horloger (2) pourvu d'un affichage analogique et comportant au moins une roue (4; 4A; 4B; 4C; 4D; 4E) solidaire en rotation d'un moyen d'affichage rotatif (14) faisant partie dudit affichage analogique, cette roue comprenant un plateau (8; 8A; 8B; 8C; 8D; 8E) avec une denture (6) définie par son bord externe et un arbre (10) perpendiculaire à ce plateau;
- un dispositif de détection de la position angulaire d'au moins un demi-axe géométrique de référence (R1 à R8) de ladite roue (4; 4A; 4B; 4C; 4D; 4E), ce dispositif de détection comprenant un capteur inductif ou capacitif (20) pourvu d'un organe de détection (24);
ledit plateau (8; 8A; 8B; 8C; 8D; 8E) de ladite roue (4; 4A; 4B; 4C; 4D; 4E) étant constitué par un matériau dont une variation de présence au-dessus ou au-dessous dudit organe de détection (24) engendre une variation d'au moins un paramètre ou une variable de ce capteur (20) dont dépend un signal de mesure fourni par celui-ci, ledit plateau (8; 8A; 8B; 8C; 8D; 8E) présentant au moins une ouverture (16; 16A; 40; 42; 60, 61; 70 à 72; 74 à 76) située dans sa région intermédiaire entre un trou central (18), prévu pour le passage dudit arbre (10) et ladite denture (6), cette ouverture servant à définir ledit au moins un demi-axe géométrique de référence (R1 à R8), ledit capteur (20) étant agencé relativement à ladite roue (4; 4A; 4B; 4C; 4D; 4E) de manière que son organe de détection (24) soit au moins partiellement au-dessous ou au-dessus de ladite ouverture dans au moins une position angulaire donnée de ladite roue.

2. Pièce d'horlogerie selon la revendication 1 dans laquelle ledit matériau constituant ledit plateau (8; 8A; 8B; 8C; 8D; 8E) est un métal électriquement conducteur.

3. Pièce d'horlogerie selon la revendication 2, dans laquelle ledit métal à une perméabilité magnétique égale à 1 ou proche de 1, par exemple de l'aluminium ou du laiton.

4. Pièce d'horlogerie selon l'une des revendications précédentes, dans laquelle ledit organe de détection est formé par une seule bobine (24) plane en spirale, le circuit électronique dudit capteur (20) définissant un oscillateur à relaxation différentiel, une variation de présence dudit matériau constituant ledit plateau (8; 8A; 8B; 8C; 8D; 8E) au-dessus ou au-dessous de ladite bobine (24) engendrant une variation de fréquence d'un signal produit par le capteur (20) qui résulte d'une variation de la valeur d'inductance de cette bobine (24) au sein dudit circuit électronique dudit capteur (20).

5. Pièce d'horlogerie selon l'une des revendications précédentes, dans laquelle ledit au moins un demi-axe géométrique de référence (R1 à R8) de ladite roue (4; 4A; 4B; 4C; 4D; 4E) part perpendiculairement de l'axe géométrique de rotation (12) dudit arbre (10) et passe par le centre géométrique de ladite ouverture.

6. Pièce d'horlogerie selon la revendication 5, dans laquelle ledit plateau (8B; 8C; 8D; 8E) de ladite roue (4B; 4C; 4D; 4E) présente une pluralité d'ouvertures situées dans la région intermédiaire de ce plateau et dont au moins une (40; 42; 70; 74 à 76) présente une dimension angulaire différente des autres ouvertures, plusieurs ouvertures définissant respectivement plusieurs demi-axes géométriques de référence (R1 à R8) de ladite roue.

7. Pièce d'horlogerie selon l'une des revendications 1 à 4, dans laquelle ledit plateau (8B) présente dans ladite région intermédiaire au moins une partie matérielle (44, 46) adjacente à ladite ouverture (40, 42), le bord de cette ouverture définie par cette partie matérielle définissant ledit au moins un demi-axe géométrique de référence (R1) de ladite roue (4B).

8. Pièce d'horlogerie selon l'une des revendications 1 à 4, dans laquelle ledit plateau (8C) présente dans sa région intermédiaire au moins ladite ouverture (60 à 63) et au moins un bras radial (64 à 67) dont la ligne médiane définit ledit au moins un demi-axe géométrique de référence (R1) de ladite roue (4C) qui est confondu avec cette ligne médiane.

9. Pièce d'horlogerie selon la revendication 8, dans laquelle il est prévu une pluralité de bras radiaux (64 à 67) séparés par une pluralité correspondante d'ouvertures (60 à 63) et situés dans ladite région intermédiaire, cette pluralité de bras reliant matériellement le moyeu (68) et la jante (69) de ladite roue (4C), au moins un (64) desdits bras ayant une dimension angulaire différente de celle des autres bras et définissant ledit demi-axe géométrique de référence.

10. Pièce d'horlogerie selon la revendication 9, dans laquelle les lignes médianes de plusieurs desdits bras (64 à 67) radiaux définissent respectivement plusieurs demi-axes géométriques de référence de ladite roue (4C).

## Patentansprüche

1. Zeitmessgerät mit:
- einem Uhrwerk (2), das mit einer analogen Anzeige versehen ist und wenigstens ein Rad (4; 4A; 4B; 4C; 4D; 4E) aufweist, das mit einem drehbaren Anzeigemittel (14) drehfest verbunden ist, das Teil der analogen Anzeige ist, wobei das Rad eine Platte (8; 8A; 8B; 8C; 8D; 8E) mit einer Verzahnung (6), die durch ihren äußeren Rand definiert wird, sowie eine Welle (10) aufweist, die senkrecht zu der Platte ist;
- einer Erfassungsvorrichtung für die Winkelposition wenigstens einer geometrischen Referenzhalbachse (R1 bis R8) des Rads (4; 4A; 4B; 4C; 4D; 4E),
wobei die Erfassungsvorrichtung einen induktiven oder kapazitiven Sensor (20) aufweist, der mit einem Erfassungselement (24) versehen ist;
wobei die Platte (8; 8A; 8B; 8C; 8D; 8E) des Rads (4; 4A; 4B; 4C; 4D; 4E) aus einem Material gebildet ist, bei dem eine Änderung des Vorhandenseins über oder unter dem Erfassungselement (24) zu einer Änderung wenigstens eines Parameters oder einer Variablen des Sensors (20) führt, von dem bzw. der ein vom Sensor geliefertes Messsignal abhängt, wobei die Platte (8; 8A; 8B; 8C; 8D; 8E) wenigstens eine Öffnung (16; 16A; 40; 42; 60, 61; 70 bis 72; 74 bis 76) aufweist, die in ihrem Zwischenabschnitt zwischen einem zentralen Loch (18), das für den Durchgang der Welle (10) vorgesehen ist, und der Verzahnung (6) angeordnet ist, wobei die Öffnung dazu dient, die wenigstens eine geometrische Referenzhalbachse (R1 bis R8) zu definieren, wobei der Sensor (20) relativ zum Rad (4; 4A; 4B; 4C; 4D; 4E) derart angeordnet ist, daß sein Erfassungselement (24) in wenigstens einer von dem Rad gegebenen Winkelposition wenigstens teilweise unter oder über der Öffnung ist.

2. Zeitmessgerät nach Anspruch 1, bei dem das die Platte (8; 8A, 8B; 8C; 8D; 8E) bildende Material ein elektrisch leitendes Metall ist.

3. Zeitmessgerät nach Anspruch 2, bei dem das Metall eine magnetische Permeabilität aufweist, die gleich 1 oder nahe bei 1 ist, beispielsweise von Aluminium oder Messing.

4. Zeitmessgerät nach einem der vorhergehenden Ansprüche, bei dem das Erfassungselement durch eine einzige ebene spiralförmige Spule (24) gebildet ist, wobei die elektronische Schaltung des Sensors (20) einen differentiellen Kippgenerator bildet, wobei eine Änderung des Vorhandenseins des die Platten (8; 8A; 8B; 8C; 8D; 8E) bildenden Materials unter oder über der Spule (24) eine Änderung der Frequenz eines Signals bewirkt, das von dem Sensor (20) erzeugt wird, was zu einer Änderung des Induktionswertes der Spule (24) in der elektronischen Schaltung des Sensors (20) führt.

5. Zeitmessgerät nach einem der vorhergehenden Ansprüche, bei dem die wenigstens eine geometrische Referenzhalbachse (R1 bis R8) des Rads (4; 4A, 4B, 4C; 4D; 4E) senkrecht von der geometrischen Rotationsachse (12) der Welle (10) ausgeht und sich durch das geometrische Zentrum der Öffnung erstreckt.

6. Zeitmessgerät nach Anspruch 5, bei dem die Platte (8; 8A; 8B; 8C; 8D; 8E) des Rads (4; 4A; 4B; 4C; 4D; 4E) eine Vielzahl von Öffnungen aufweist, die im Zwischenabschnitt der Platte angeordnet sind und von denen wenigstens eine (40; 42; 70; 74 bis 76) eine Winkelabmessung aufweist, die sich von denen der anderen Öffnungen unterscheidet, wobei mehrere Öffnungen entsprechend mehrere geometrische Referenzhalbachsen (R1 bis R8) des Rads definieren.

7. Zeitmessgerät nach einem der Ansprüche 1 bis 4, bei dem die Platte (8B) in dem Zwischenabschnitt wenigstens einen Materialbereich (44, 46) benachbart zur Öffnung (40, 42) aufweist, wobei der Rand der Öffnung, der durch diesen Materialbereich definiert wird, die wenigstens eine geometrische Referenzhalbachse (R1) des Rads (4B) definiert.

8. Zeitmessgerät nach einem der Ansprüche 1 bis 4, bei dem die Platte (8C) in ihrem Zwischenabschnitt wenigstens die Öffnung (60 bis 63) und wenigstens einen radialen Arm (64 bis 67) aufweist, dessen Mittellinie die wenigstens eine geometrische Referenzhalbachse (R1) des Rads (4C) definiert, die mit der Mittellinie zusammenfällt.

9. Zeitmessgerät nach Anspruch 8, bei dem eine Vielzahl radialer Arme (64 bis 67) vorgesehen ist, die durch eine Vielzahl entsprechender Öffnungen (60 bis 63) getrennt und in dem Zwischenabschnitt angeordnet sind, wobei die Vielzahl der Arme die Nabe (68) und den Radkranz (69) des Rads (4C) körperlich verbindet, wobei wenigstens einer (64) der Arme eine Winkelabmessung aufweist, die sich von derjenigen der anderen Arme unterscheidet und die geometrische Referenzhalbachse definiert.

10. Zeitmessgerät nach Anspruch 9, bei dem die Mittellinien der Vielzahl der radialen Arme (64 bis 67) eine entsprechende Vielzahl geometrischer Referenzhalbachsen des Rads (4C) definieren.

## Claims

1. Timepiece including:
- a clockwork movement (2) provided with an analogue display and including at least one wheel (4; 4A; 4B; 4C; 4D; 4E) fixed in rotation to a rotating analogue display means (14) forming part of said analogue display, said wheel including a plate (8; 8A; 8B; 8C; 8D; 8E) with a toothing (6) defined by its external edge and a shaft (10) perpendicular to said plate;
- a device for detecting the angular position of at least one reference geometric semi-axis (R1 to R8) of said wheel (4; 4A; 4B; 4C; 4D; 4E), this detection device including a inductive or capacitive sensor (20) provided with a detection element (24);
said plate (8; 8A; 8B; 8C; 8D; 8E) of said wheel (4; 4A; 4B; 4C; 4D; 4E) being formed by a material a variation in whose presence above or below the detection element (24) generates a variation in at least one parameter or one variable of said sensor (20) on which a measuring signal provided by the latter depends, said plate (8; 8A; 8B; 8C; 8D; 8E) having at least one opening (16; 16A, 40; 42; 60; 61; 70 to 72; 74 to 76) situated in the intermediate region thereof between a central hole (18), provided for the passage of said shaft (10), and said toothing (6), this opening being used to define said at least one reference geometric semi-axis (R1 to R8), said sensor (20) being arranged in relation to the wheel (4; 4A; 4B; 4C; 4D; 4E) so that its detection element is at least partially above or below said opening in at least one given angular position of said wheel.

2. Timepiece according to claim 1, wherein said material constituting said plate (8; 8A; 8B; 8C; 8D; 8E) is an electrically conductive metal.

3. Timepiece according to claim 2, wherein said metal has a magnetic permeability equal to 1 or close to 1, for example aluminium or brass.

4. Timepiece according to any of the preceding claims, wherein said detection element is formed by a single flat spiral coil (24), the electronic circuit of said sensor (20) defining a differential relaxation oscillator, a variation in the presence of said material constituting said plate (8; 8A; 8B; 8C; 8D; 8E) above or below said coil (24) generating a variation in frequency of a signal generated by the sensor (20) which results from a variation in the inductance value of said coil (24) within said electronic circuit of said sensor (20).

5. Timepiece according to any of the preceding claims, wherein said at least one reference geometric semi-axis (R1 to R8) of said wheel (4; 4A; 4B; 4C; 4D; 4E) starts perpendicular to the geometric axis of rotation (12) of said shaft (10) and passes through the geometric centre of said opening.

6. Timepiece according to claim 5, wherein said plate (8B; 8C; 8D; 8E) of said wheel (4B; 4C; 4D; 4E) has a plurality of openings situated in the intermediate region of said plate and at least one (40; 42; 70; 74 to 76) of which has a different angular dimension to the other openings, several openings defining respectively several reference geometric semi-axes (R1 to R8) of said wheel.

7. Timepiece according to any of claims 1 to 4, wherein said plate (8B) has in said intermediate region at least one material portion (44, 46) adjacent to said opening (40, 42), the edge of said opening defined by said material portion defining said at least one reference geometric semi-axis (R1) of said wheel (4B).

8. Timepiece according to any of claims 1 to 4, wherein said plate (8C) has in its intermediate region at least said opening (60 to 63)and at least one radial arm (64 to 67) whose median line defines said at least one reference geometric semi-axis (R1) of said wheel (4C) which is identical to said median line.

9. Timepiece according to claim 8, wherein a plurality of radial arms (64 to 67) are provided separated by a corresponding plurality of openings (60 to 63) and situated in said intermediate region, said plurality of arms materially linking the hub (68) and the wheel rim (69) of said wheel (4C), at least one (64) of said arms having a different angular dimension to that of the other arms and defining said reference geometric semi-axis.

10. Timepiece according to claim 9, wherein the median lines of several of said radial arms (64 to 67) define respectively several reference geometric semi-axes of said wheel (4C).
